# EUROPEAN PATENT APPLICATION

(11) **EP 4 611 047 A1**
(43) Date of publication of application: **03.09.2025**
(21) Application number: 24822424.8
(22) Date of filing: 28.04.2024
(51) Int. Cl.: H01L 31/0747, H01L 31/18

(54) **BACK-CONTACT CELL AND MANUFACTURING METHOD THEREFOR, AND PHOTOVOLTAIC MODULE**

(30) Priority: 13.06.2023 CN 202310702158
(71) Applicant: Longi Solar Technology (Taizhou) Co., Ltd., Taizhou, Jiangsu 225300 (CN)
(72) Inventor: WANG, Tao, Taizhou, Jiangsu 225300 (CN); YU, Long, Taizhou, Jiangsu 225300 (CN); TONG, Hongbo, Taizhou, Jiangsu 225300 (CN); LI, Hua, Taizhou, Jiangsu 225300 (CN)
(74) Representative: Pfenning, Meinig & Partner mbB
(86) International application number: PCT/CN2024/090414
(87) International publication number: WO 2024/255469

(57) **Abstract**

The present application belongs to the field of photovoltaic technologies, and specifically discloses a back-contacted solar cell and a manufacturing method therefor, and a photovoltaic module. the back-contacted solar cell includes: a semiconductor substrate, where the semiconductor substrate has a first surface and a second surface arranged opposite to each other, and the first surface has a textured structure; and a tunneling passivation layer and an N-type doped polycrystalline silicon layer that are sequentially stacked on a local region of the second surface in a thickness direction of the semiconductor substrate, where a ratio of a thickness of the N-type doped polycrystalline silicon layer that is located on an edge region of the second surface to a thickness of the N-type doped polycrystalline silicon layer that is located on a central region of the second surface is greater than or equal to 1 and less than or equal to 1.2.

## Description

The present application claims priority to Chinese Patent Application No. 202310702158.2 field with the China National Intellectual Administration Property on June 13, 2023 and entitled "BACK-CONTACTED SOLAR CELL AND MANUFACTURING METHOD THEREFOR, AND PHOTOVOLTAIC MODULE", which is incorporated herein by reference in its entirety.

### TECHNICAL FIELD

The present application relates to the field of photovoltaic technologies, and specifically to a back-contacted solar cell and a manufacturing method therefor, and a photovoltaic module.

### BACKGROUND

A tunneling passivation back-contacted solar cell refers to a solar cell that has a back surface on which a positive electrode and a negative electrode are both located, has a front surface not obstructed by a metal electrode, and has a tunneling passivation contact structure. Because of advantages such as a large light-absorbing area and a low carrier back-surface recombination rate, the tunneling passivation back-contacted solar cell has attracted wide attention from the photovoltaic academic community and industrial community, and becomes a hot development direction of high-efficiency solar cell technologies.

However, in a tunneling passivation back-contacted solar cell formed by using a related manufacturing method, an N-type doped polycrystalline silicon layer with a doping element of phosphorus has a poor morphology, leading to poor operating performance of the tunneling passivation back-contacted solar cell.

### SUMMARY

An objective of the present application is to provide a back-contacted solar cell and a manufacturing method therefor, and a photovoltaic module.

Specifically, the present application relates to the following aspects:
According to a first aspect, the present application discloses a back-contacted solar cell. The back-contacted solar cell includes: a semiconductor substrate, where the semiconductor substrate has a first surface and a second surface arranged opposite to each other, and the first surface has a textured structure; and a tunneling passivation layer and an N-type doped polycrystalline silicon layer that are sequentially stacked on a local region of the second surface in a thickness direction of the semiconductor substrate. A ratio of a thickness of the N-type doped polycrystalline silicon layer that is located on an edge region of the second surface to a thickness of the N-type doped polycrystalline silicon layer that is located on a central region of the second surface is greater than or equal to 1 and less than or equal to 1.2.

When the foregoing technical solution is used, a tunneling passivation contact structure that is formed by the tunneling passivation layer and the N-type doped polycrystalline silicon layer can achieve excellent interface passivation and carrier selective collection, facilitating improvement of photoelectric conversion efficiency of the back-contacted solar cell. In addition, compared with the related technology in which a ratio of a thickness of an edge part to a thickness of a central part of an N-type doped polycrystalline silicon layer is greater than 1.3, in the present application, a ratio of a thickness of the N-type doped polycrystalline silicon layer that is located on an edge region of the second surface to a thickness of the N-type doped polycrystalline silicon layer that is located on a central region of the second surface is greater than or equal to 1 and less than or equal to 1.2. In this case, a difference between the thickness of the edge part and the thickness of the central part of the N-type doped polycrystalline silicon layer is small. In this case, in an actual manufacturing process, a tunneling passivation material layer and an intrinsic amorphous silicon material layer used for manufacturing the tunneling passivation layer and the N-type doped polycrystalline silicon layer are usually formed by using a process such as chemical vapor deposition. Based on this, when the difference between the thickness of the edge part and the thickness of the central part of the N-type doped polycrystalline silicon layer is small, a difference between a thickness of an edge part and a thickness of a central part of the intrinsic amorphous silicon material layer for forming the N-type doped polycrystalline silicon layer is also small. Because parts of the intrinsic amorphous silicon material layer that are parallel to the second surface are all formed simultaneously, a chemical dose ratio of the intrinsic amorphous silicon material located on the edge region of the second surface to the intrinsic amorphous silicon material located on the central region of the second surface is approximately equal to 1. Therefore, when the difference between the thickness of the edge part and the thickness of the central part of the intrinsic amorphous silicon material layer is small, a difference between structural compactness of the edge part and structural compactness of the central part of the intrinsic amorphous silicon material layer is small. Correspondingly, when the phosphorus diffusion treatment is performed on the intrinsic amorphous silicon material layer, a difference between compactness of an edge part of a phosphorus-silicon glass layer obtained by a reaction between silicon in the intrinsic amorphous silicon material layer and oxygen in a diffusion ambient and compactness of a central part of the phosphorus-silicon glass layer is also small, so that the edge part of the phosphorus-silicon glass layer has high anti-corrosion performance that is approximately the same as that of the central part of the phosphorus-silicon glass layer. Therefore, in a process in which the texturing treatment is performed on at least the first surface of the semiconductor substrate, a part, which is used for forming the N-type doped polycrystalline silicon layer, of the N-type doped polycrystalline silicon material layer located below the phosphorus-silicon glass layer can be well protected by using the phosphorus-silicon glass layer, so that the morphology and the forming range of the obtained N-type doped polycrystalline silicon layer satisfy a target requirement, thereby facilitating collection of carriers, reducing reverse leakage current, and further facilitating improvement of the photoelectric conversion efficiency of the back-contacted solar cell.

In an embodiment, uniformity of the textured structure on the first surface is greater than or equal to 85% and less than 100%.

When the foregoing technical solution is used, textured surfaces on the regions of the first surface have high uniformity, so that all the regions of the first surface have high light transmittance performance. Therefore, more light can be transmitted into the semiconductor substrate through the first surface, thereby further improving the photoelectric conversion efficiency of the back-contacted solar cell.

In an embodiment, a region of the second surface on which the tunneling passivation layer and the N-type doped polycrystalline silicon layer are not stacked is a polished surface or a textured structure.

In an embodiment, the thickness of the N-type doped polycrystalline silicon layer that is located on the edge region of the second surface is greater than or equal to 175 nm and less than or equal to 225 nm.

When the foregoing technical solution is used, the thickness of the N-type doped polycrystalline silicon layer located on the edge region of the second surface is within the foregoing range, to avoid a case that the overall thickness of the N-type doped polycrystalline silicon layer is small because of the foregoing small thickness value and does not satisfy the target requirement, and avoid a case that the difficulty of manufacturing an N-type doped polycrystalline silicon layer having high thickness uniformity is high, thereby facilitating obtaining of the back-contacted solar cell. In addition, a case that the anti-corrosion performance of the phosphorus-silicon glass layer located on the edge part of the N-type doped polycrystalline silicon material layer after the phosphorus diffusion treatment is poor due to the foregoing large thickness value can be further avoided, to ensure that the phosphorus-silicon glass layer in the process of performing the texturing treatment can well include the parts that are in the N-type doped polycrystalline silicon material layer and that are used for forming the N-type doped polycrystalline silicon layer, and ensure that the N-type doped polycrystalline silicon layer has a good morphology and a forming range that satisfies the target requirement.

In an embodiment, the thickness of the N-type doped polycrystalline silicon layer that is located on the central region of the second surface is greater than or equal to 150 nm and less than or equal to 200 nm.

In an embodiment, an average doping concentration of the N-type doped polycrystalline silicon layer is greater than or equal to 3.5 × 10²⁰/cm³ and less than or equal to 4.0 × 10²⁰/cm³.

When the foregoing technical solution is used, the average doping concentration of the impurity in the N-type doped polycrystalline silicon layer is within the foregoing range, to properly reduce the doping concentration of the impurity in the N-type doped polycrystalline silicon layer in the present application compared with an N-type doped polycrystalline silicon layer (where the average doping concentration of the impurity in the N-type doped polycrystalline silicon layer is greater than 5.0 × 10²⁰/cm³) in the related technology, while ensuring that the N-type doped polycrystalline silicon layer has an excellent carrier selective collection function without affecting the contact resistance between the N-type doped polycrystalline silicon layer and the negative electrode. Correspondingly, an average doping concentration of the impurity in the N-type doped polycrystalline silicon material layer used for manufacturing the N-type doped polycrystalline silicon layer is also low. Based on this, in an actual manufacturing process, an average doping concentration of the impurity in the N-type doped polycrystalline silicon material layer after the phosphorus diffusion treatment is in direct proportion to an average doping concentration of the impurity in the phosphorus-silicon glass layer formed on the N-type doped polycrystalline silicon material layer after the phosphorus diffusion treatment. Therefore, properly reducing the doping concentration of the impurity in the N-type doped polycrystalline silicon layer also represents reduction of the average doping concentration of the impurity (the impurity includes phosphorus) in the phosphorus-silicon glass layer. In this case, because the doping concentration of phosphorus in the phosphorus-silicon glass layer is inversely proportional to the anti-corrosion performance of the phosphorus-silicon glass layer, properly reducing the doping concentration of phosphorus in the phosphorus-silicon glass layer can further improve the anti-corrosion performance of the phosphorus-silicon glass layer, to further ensure that the N-type doped polycrystalline silicon layer has a good morphology and a forming range that satisfies the target requirement.

According to a second aspect, the present application further discloses a photovoltaic module. The photovoltaic module includes the back-contacted solar cell provided in the foregoing first aspect and the embodiments thereof.

For beneficial effects of the second aspect in the present application, reference is made to the analysis of the beneficial effects of the first aspect and various embodiments of the first aspect, and details are not described herein.

According to a third aspect, the present application further discloses a manufacturing method for a back-contacted solar cell. The manufacturing method for a back-contacted solar cell includes: first, providing a semiconductor substrate, where the semiconductor substrate has a first surface and a second surface arranged opposite to each other; then, sequentially stacking a tunneling passivation material layer and an intrinsic amorphous silicon material layer on a side of the second surface of the semiconductor substrate in a thickness direction of the semiconductor substrate; then, performing phosphorus diffusion treatment on the intrinsic amorphous silicon material layer, to form an N-type doped polycrystalline silicon material layer from the intrinsic amorphous silicon material layer, and form a phosphorus-silicon glass layer on the N-type doped polycrystalline silicon material layer, where a ratio of a thickness of the N-type doped polycrystalline silicon material layer that is located on an edge region of the second surface to a thickness of the N-type doped polycrystalline silicon material layer that is located on a central region of the second surface is greater than or equal to 1 and less than or equal to 1.2; then, performing texturing treatment on the first surface of the semiconductor substrate under a mask of the phosphorus-silicon glass layer, to form a textured structure from the first surface; then, performing patterning treatment on the phosphorus-silicon glass layer, and the tunneling passivation material layer and the N-type doped polycrystalline silicon material layer that are stacked, to form a tunneling passivation layer and an N-type doped polycrystalline silicon layer that are stacked on a local region of the second surface; and then, removing the remaining phosphorus-silicon glass layer.

For beneficial effects of the third aspect in the present application, reference is made to the analysis of the beneficial effects of the first aspect and various embodiments of the first aspect, and details are not described herein.

In an embodiment, an ambient pressure for forming the intrinsic amorphous silicon material layer is greater than or equal to 100 mTorr and less than or equal to 150 mTorr.

When the foregoing technical solution is used, in an actual process of manufacturing the intrinsic amorphous silicon material layer, in a specific range, reducing the ambient pressure can improve a molecular free path, to cause a reactive molecular group to reach various regions on the surface of the tunneling passivation material layer more quickly, rather than gather at a same position. Based on this, the ambient pressure for forming the intrinsic amorphous silicon material layer is within the foregoing range, to prevent a large thickness of the edge part of the intrinsic amorphous silicon material layer caused by a large ambient pressure, ensure that a difference between the thicknesses of the edge part and the central part of the intrinsic amorphous silicon material layer is small, and ensure that a structure of the edge part of the intrinsic amorphous silicon material layer is as compact as a structure of the central part of the intrinsic amorphous silicon material layer, so that each part, in a direction parallel to the second surface, of the phosphorus-silicon glass layer formed after the phosphorus diffusion treatment has high anti-corrosion performance, to ensure that the morphology and the forming range of the formed N-type doped polycrystalline silicon layer satisfy the target requirement. In addition, low manufacturing process efficiency caused by a low ambient pressure can also be prevented.

In an embodiment, a gas flow rate for forming the intrinsic amorphous silicon material layer is greater than or equal to 0.9 slm and less than or equal to 1.2 slm.

When the foregoing technical solution is used, in an actual process of manufacturing the intrinsic amorphous silicon material layer, in a particular range, reducing a gas flow rate can reduce a total gas flow rate in a diffusion device, to reduce a disturbance degree caused by the gas flow in the diffusion device, facilitate optimization of deposition quality of a part of the intrinsic amorphous silicon material layer located on the edge region of the second surface, and ensure that a structure of the edge part of the intrinsic amorphous silicon material layer is as compact as a structure of the central part of the intrinsic amorphous silicon material layer, so that each part, in a direction parallel to the second surface, of the phosphorus-silicon glass layer formed after the phosphorus diffusion treatment has high anti-corrosion performance, to ensure that the morphology and the forming range of the formed N-type doped polycrystalline silicon layer satisfy the target requirement. In addition, low manufacturing process efficiency caused by a low gas flow rate can also be prevented.

In an embodiment, after the performing phosphorus diffusion treatment on the intrinsic amorphous silicon material layer, and before the performing texturing treatment on the first surface of the semiconductor substrate under a mask of the phosphorus-silicon glass layer, the patterning treatment is performed only on the phosphorus-silicon glass layer, and a part of the phosphorus-silicon glass layer remained on a local region of the N-type doped polycrystalline silicon material layer. In this case, patterning treatment is performed on the tunneling passivation material layer and the N-type doped polycrystalline silicon material layer that are stacked under the mask of the phosphorus-silicon glass layer while texturing treatment is performed on the first surface of the semiconductor substrate.

When the foregoing technical solution is used, patterning treatment is performed on the phosphorus-silicon glass layer on a side of the second surface before the texturing treatment is performed, so that in a subsequent process of the texturing treatment, a texturing corrosion liquid not only can form a textured surface on at least the first surface, but also can implement, under the mask of the remaining part of the phosphorus-silicon glass layer, patterning treatment on the N-type doped polycrystalline silicon material layer, to obtain the N-type doped polycrystalline silicon layer, thereby improving the manufacturing process efficiency of the back-contacted solar cell while ensuring that the morphology and the forming range of the N-type doped polycrystalline silicon layer satisfy the target requirement.

In an embodiment, an amorphous silicon layer is formed as well on a side surface of the semiconductor substrate and a part of the first surface while the intrinsic amorphous silicon material layer is formed on the second surface of the semiconductor substrate in the thickness direction of the semiconductor substrate. A width of a formation region of the amorphous silicon layer on the first surface is greater than or equal to 0 and less than 10 mm. A width direction of the formation region is parallel to a radial direction of the semiconductor substrate. In addition, after the phosphorus diffusion treatment, a doped layer deposited around is formed from the amorphous silicon layer, and a phosphorus-silicon glass layer deposited around is formed on the doped layer deposited around. In the foregoing case, after the performing phosphorus diffusion treatment on the intrinsic amorphous silicon material layer, and before the performing texturing treatment on the first surface of the semiconductor substrate under a mask of the phosphorus-silicon glass layer, the manufacturing method for a back-contacted solar cell further includes: removing the phosphorus-silicon glass layer deposited around and the doped layer deposited around.

When the foregoing technical solution is used, before the texturing treatment is performed, it is necessary to sequentially remove the phosphorus-silicon glass layer deposited around and the doped layer deposited around that are formed due to wrap-around. The corrosion liquid used to remove the doped layer deposited around also affects the surface of the part of the first surface of the semiconductor substrate that is covered by the doped layer deposited around. In this way, the surface of the part is formed with a cellular structure. However, the surface of the central region of the first surface of the semiconductor substrate that is not covered by the doped layer deposited around is flat. Consequently, after the subsequent texturing treatment, dimensions of the textured structures on the edge region and the central region of the first surface are inconsistent, thereby affecting the light trapping effect of the first surface. In this case, compared with a related technology in which a width of a formation region of a doped layer deposited around, on a first surface, that is formed when a back-contacted solar cell is manufactured is greater than 10 mm, in the present application, when a width of a formation region of the amorphous silicon layer on the first surface is greater than or equal to 0 and less than 10 mm, a wrap-around width thereof is small, which facilitates improvement of uniformity of textured structures located on regions of the first surface, further facilitates improvement of a light trapping effect of the first surface, and further improves photoelectric conversion efficiency of the back-contacted solar cell.

In an embodiment, a thickness of the phosphorus-silicon glass layer is greater than or equal to 60 nm and less than or equal to 65 nm.

When the foregoing technical solution is used, the thickness of the phosphorus-silicon glass layer is within the foregoing range, to avoid a case that the anti-corrosion performance of the phosphorus-silicon glass layer is poor due to a small thickness of the phosphorus-silicon glass layer, and ensure that the morphology and the forming range of the formed N-type doped polycrystalline silicon layer satisfy the target requirement. In addition, a case that a large quantity of consumables for manufacturing the intrinsic amorphous silicon material layer and the phosphorus-silicon glass layer are used due to a large thickness of the phosphorus-silicon glass layer can be further avoided, to facilitate control of manufacturing costs of the back-contacted solar cell.

In an embodiment, an average thickness of the intrinsic amorphous silicon material layer is H1, an average thickness of the phosphorus-silicon glass layer is H2, an average thickness of the N-type doped polycrystalline silicon material layer is H3, and 40% of H2 < H1-H3 < 60% of H2.

When the foregoing technical solution is used, as described above, forming the phosphorus-silicon glass layer needs to consume a silicon element in the N-type doped polycrystalline silicon material layer. Based on this, that the average thicknesses of the intrinsic amorphous silicon material layer, the phosphorus-silicon glass layer, and the N-type doped polycrystalline silicon material layer satisfy the foregoing condition indicates that the formation thickness of the intrinsic amorphous silicon material layer is proper, and the compactness and structural compactness uniformity of the regions of the intrinsic amorphous silicon material layer that are in a direction parallel to the second surface are both high. Therefore, after the phosphorus-silicon glass layer is formed, the consumed thickness of the N-type doped polycrystalline silicon material layer can satisfy a theoretical consumption amount of an N-type doped polycrystalline silicon material layer having high compactness (that is, the thickness of the phosphorus-silicon glass layer is roughly equal to half of a reduction amount of the thickness of the N-type doped polycrystalline silicon material layer), or has a small difference from the foregoing theoretical consumption amount, thereby indicating that the optimized phosphorus-silicon glass layer has high forming quality, and ensuring that the formed N-type doped polycrystalline silicon layer has a good morphology and a forming range that satisfies the target requirement.

In an embodiment, a condition of the phosphorus diffusion treatment is:
a deposition process temperature is greater than or equal to 850°C and less than or equal to 900°C; and/or a deposition process ambient pressure is greater than or equal to 150 mbar and less than or equal to 200 mbar; and/or a phosphorus source pressure is greater than or equal to 250 mbar and less than or equal to 450 mbar; and/or a nitrogen flow rate is greater than or equal to 1500 sccm and less than or equal to 2000 sccm; and/or an oxygen flow rate is greater than or equal to 750 sccm and less than or equal to 1000 sccm; and/or a temperature in post-oxidation process is greater than or equal to 850°C and less than or equal to 900°C; and/or an oxygen flow rate in post-oxidation process is greater than or equal to 5000 sccm and less than or equal to 10000 sccm.

When the foregoing technical solution is used, in an actual manufacturing process, by changing the deposition process temperature, the deposition process ambient pressure, the phosphorus source pressure, the nitrogen flow rate, and the oxygen flow rate during the foregoing phosphorus diffusion treatment, the average doping concentration of the impurity in the formed phosphorus-silicon glass layer and the average doping concentration of the impurity in the formed N-type doped polycrystalline silicon material layer can be regulated. Based on this, when at least one of the deposition process temperature, the deposition process ambient pressure, the phosphorus source pressure, the nitrogen flow rate, and the oxygen flow rate falls within the foregoing corresponding range, the average doping concentration of phosphorus in the phosphorus-silicon glass layer can be properly reduced, so that the phosphorus-silicon glass layer has high anti-corrosion performance, thereby ensuring that the N-type doped polycrystalline silicon layer formed based on the N-type doped polycrystalline silicon material layer has a good morphology and a forming range that satisfies the target requirement. In addition, the thickness of the formed phosphorus-silicon glass layer can be regulated by changing the temperature in post-oxidation process and the oxygen flow rate in post-oxidation process during the phosphorus diffusion treatment. Based on this, when at least one of the temperature in post-oxidation process and the oxygen flow rate in post-oxidation process falls within the foregoing corresponding range, the formation thickness of the phosphorus-silicon glass layer can be properly increased, thereby improving the anti-corrosion performance of the phosphorus-silicon glass layer.

The foregoing descriptions are merely an overview of the technical solutions in the present application. In order that technical means of the present application can be understood more clearly so that the technical solutions can be implemented according to content of the descriptions, and in order that the foregoing and other objectives, features, and advantages of the present application can be understood more clearly, specific embodiments of the present application are described below.

### BRIEF DESCRIPTION OF THE DRAWINGS

To describe technical solutions in embodiments of the present application or the related art more clearly, the following briefly introduces accompanying drawings required for describing the embodiments or the related art. Apparently, the accompanying drawings in the following descriptions show some of the embodiments of the present application, and a person of ordinary skill in the art still derives other drawings from these accompanying drawings without creative efforts.
FIG. 1 is a schematic longitudinal cross-sectional view of a structure of a back-contacted solar cell according to an embodiment of the present application;
FIG. 2 is a schematic diagram of an SEM morphology of a part, located on an edge region of a second surface, of an N-type doped polycrystalline silicon layer formed in the related technology;
FIG. 3 is a schematic diagram of an SEM morphology of a part of an N-type doped polycrystalline silicon layer located on an edge region of a second surface according to an embodiment of the present application;
FIG. 4 is a first schematic longitudinal cross-sectional view of a structure of a back-contacted solar cell in a manufacturing process according to an embodiment of the present application;
FIG. 5 is a second schematic longitudinal cross-sectional view of a structure of a back-contacted solar cell in a manufacturing process according to an embodiment of the present application;
FIG. 6 is a third schematic longitudinal cross-sectional view of a structure of a back-contacted solar cell in a manufacturing process according to an embodiment of the present application;
FIG. 7 is a fourth schematic longitudinal cross-sectional view of a structure of a back-contacted solar cell in a manufacturing process according to an embodiment of the present application;
FIG. 8 is a fifth schematic longitudinal cross-sectional view of a structure of a back-contacted solar cell in a manufacturing process according to an embodiment of the present application;
FIG. 9 is a sixth schematic longitudinal cross-sectional view of a structure of a back-contacted solar cell in a manufacturing process according to an embodiment of the present application; and
FIG. 10 is a seventh schematic longitudinal cross-sectional view of a structure of a back-contacted solar cell in a manufacturing process according to an embodiment of the present application.
Reference numerals: 11 is a semiconductor substrate, 12 is a tunneling passivation material layer, 13 is an intrinsic amorphous silicon material layer, 14 is an amorphous silicon layer, 15 is an N-type doped polycrystalline silicon material layer, 16 is a phosphorus-silicon glass layer, 17 is a doped layer deposited around, 18 is a phosphorus-silicon glass layer deposited around, 19 is a textured surface, 20 is a tunneling passivation layer, 21 is an N-type doped polycrystalline silicon layer, 22 is a positive electrode, and 23 is a negative electrode.

### DETAILED DESCRIPTION

To make the objectives, technical solutions, and advantages of the embodiments of the present application clearer, the following clearly and completely describes the technical solutions in the embodiments of the present application with reference to the accompanying drawings in the embodiments of the present application. Apparently, the described embodiments are some rather than all of the embodiments of the present application. All other embodiments obtained by a person of ordinary skill in the art based on the embodiments of the present application without creative efforts shall fall within the protection scope of the present application.

A tunneling passivation back-contacted solar cell refers to a solar cell that has a back surface on which a positive electrode and a negative electrode are both located, has a front surface not obstructed by a metal electrode, and has a tunneling passivation contact structure. Because of advantages such as a large light-absorbing area and a low carrier back-surface recombination rate, the tunneling passivation back-contacted solar cell has attracted wide attention from the photovoltaic academic community and industrial community, and becomes a hot development direction of high-efficiency solar cell technologies.

Specifically, in the related technology, the tunneling passivation back-contacted solar cell usually includes at least a semiconductor substrate, and a tunneling passivation layer and an N-type doped polycrystalline silicon layer that are sequentially stacked on a local region of a back surface of the semiconductor substrate in a thickness direction of the semiconductor substrate. In this case, in an actual process of manufacturing the foregoing tunneling passivation back-contacted solar cell, after a tunneling passivation material layer and an intrinsic amorphous silicon material layer that entirely cover the back surface of the semiconductor substrate are sequentially formed, phosphorus diffusion treatment is performed on the intrinsic amorphous silicon material layer, to form an N-type doped polycrystalline silicon material layer from the intrinsic amorphous silicon material layer, and form a phosphorus-silicon glass layer on the N-type doped polycrystalline silicon material layer. Next, under the mask of the phosphorus-silicon glass layer, texturing treatment is performed on at least a light facing surface of the semiconductor substrate, so that a textured surface is formed from at least the light facing surface, and further, more light is transmitted to the semiconductor substrate through the light facing surface, thereby facilitating improvement of the photoelectric conversion efficiency of the tunneling passivation back-contacted solar cell. In addition, the phosphorus-silicon glass layer formed in the phosphorus diffusion treatment is directly used as a masking layer for protecting the N-type doped polycrystalline silicon layer, and another masking layer does not need to be additionally formed to protect the N-type doped polycrystalline silicon layer, to simplify the manufacturing process operations of the tunneling passivation back-contacted solar cell, thereby improving the manufacturing process efficiency.

However, a thickness of an edge part of an intrinsic amorphous silicon material layer formed by using a related manufacturing method is large, and a thickness of a central part of the intrinsic amorphous silicon material layer is small; and a difference between the thickness of the edge part and the thickness of the central part of the intrinsic amorphous silicon material layer is large (a ratio between the thickness of the edge part and the thickness of the central part is usually greater than 1.3). In this case, because parts of the intrinsic amorphous silicon material layer that are parallel to the back surface are all formed simultaneously, a chemical dose ratio of the intrinsic amorphous silicon material located on the edge region of the back surface to the intrinsic amorphous silicon material located on the central region of the back surface is approximately equal to 1. Therefore, when the difference between the thickness of the edge part and the thickness of the central part of the intrinsic amorphous silicon material layer is large, a structure of the edge part of the intrinsic amorphous silicon material layer is more loose. When the phosphorus diffusion treatment is performed, the phosphorus-silicon glass layer is formed by consuming the silicon element in the intrinsic amorphous silicon material layer and causing the silicon element to react with oxygen in a diffusion ambient. Therefore, when the structure of the edge part of the intrinsic amorphous silicon material layer is more loose, the forming quality of the phosphorus-silicon glass layer located on the edge part of the intrinsic amorphous silicon material layer is poor. Therefore, the anti-corrosion performance of the phosphorus-silicon glass layer is poor. As a result, in a texturing treatment process, it is difficult for the phosphorus-silicon glass layer to well protect the N-type doped polycrystalline silicon material layer located below the phosphorus-silicon glass layer. Consequently, the morphology of the N-type doped polycrystalline silicon layer formed based on the N-type doped polycrystalline silicon material layer is poor, and the forming range of the edge region is small, which is not beneficial to carrier collection, leading to poor operating performance of the tunneling passivation back-contacted solar cell.

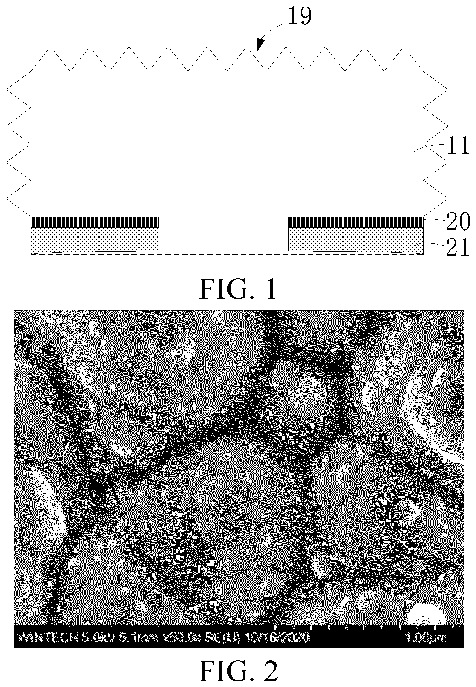

To resolve the foregoing technical problems, according to a first aspect, an embodiment of the present application provides a back-contacted solar cell. As shown in FIG. 1, the back-contacted solar cell includes: a semiconductor substrate 11, where the semiconductor substrate 11 has a first surface and a second surface arranged opposite to each other, and the first surface has a textured structure; and a tunneling passivation layer 20 and an N-type doped polycrystalline silicon layer 21 that are sequentially stacked on a local region of the second surface in a thickness direction of the semiconductor substrate 11. A doping element in the N-type doped polycrystalline silicon layer 21 includes phosphorus, and a ratio of a thickness of the N-type doped polycrystalline silicon layer 21 that is located on an edge region of the second surface to a thickness of the N-type doped polycrystalline silicon layer 21 that is located on a central region of the second surface is greater than or equal to 1 and less than or equal to 1.2.

It should be noted that, when the first surface of the semiconductor substrate 11 is a light facing surface, the second surface is a back surface. When the first surface of the semiconductor substrate 11 is a back surface, the second surface is a light facing surface. This is not specifically limited in the present application. A related description is provided below by using an example in which the first surface of the semiconductor substrate 11 is a light facing surface and the second surface is a back surface.

Specifically, in terms of materials, a material of the semiconductor substrate is a semiconductor material, for example, silicon, germanium-silicon, or germanium. In terms of conductivity types, the semiconductor substrate is an N-type semiconductor substrate or is a P-type semiconductor substrate.

In terms of structures, a specific structure of the semiconductor substrate is determined according to a conduction type of the semiconductor substrate and an actual application scenario.

For example, when the semiconductor substrate is a P-type semiconductor substrate, in a direction parallel to the back surface, the back surface of the semiconductor substrate has a P-type region that is alternately spaced apart from the tunneling passivation layer and the N-type doped polycrystalline silicon layer that are stacked. In this case, the P-type region is a back surface field of the back-contacted solar cell. In other words, in the back-contacted solar cell provided in this embodiment of the present application, the back surface field is a region of the P-type semiconductor substrate, and no additional doping treatment needs to be performed to form the back surface field, thereby simplifying the manufacturing process operations of the back-contacted solar cell, and improving the manufacturing process efficiency. In addition, problems such as a short minority carrier lifetime of the semiconductor substrate and difficult removal of an edge PN junction that are caused because N-type high-temperature doping and P-type high-temperature doping need to be performed on a side of the back surface can be further prevented from occurring, thereby facilitating improvement of the yield of the back-contacted solar cell.

Certainly, when the semiconductor substrate is a P-type semiconductor substrate, a P-type doped region is alternatively formed on a local region of the back surface of the semiconductor substrate. In a direction parallel to the back surface, the P-type doped region is alternately spaced apart from the tunneling passivation layer and the N-type doped polycrystalline silicon layer that are stacked.

For example, when the semiconductor substrate is an N-type semiconductor substrate, a P-type doped region is formed in a local region of the back surface of the semiconductor substrate or on a local region of the back surface. In a direction parallel to the back surface, the P-type doped region is alternately spaced apart from the tunneling passivation layer and the N-type doped polycrystalline silicon layer that are stacked.

In terms of morphology, the light facing surface of the semiconductor substrate is a textured surface. The side surface of the semiconductor substrate is a polished surface, or is a textured surface. A surface of a region that is on the back surface of the semiconductor substrate and that is not covered by the tunneling passivation layer and the N-type doped polycrystalline silicon layer that are stacked is a textured surface, or is a polished surface.

For the foregoing tunneling passivation layer, a material and a thickness of the tunneling passivation layer are set according to an actual requirement, which is not specifically limited herein. For example, the material of the tunneling passivation layer includes one or more of silicon oxide, aluminum oxide, titanium oxide, hafnium oxide, gallium oxide, titanium pentoxide, niobium pentoxide, silicon nitride, silicon carbonitride, aluminum nitride, titanium nitride, and titanium carbonitride.

For the foregoing N-type doped polycrystalline silicon layer, a ratio of a thickness of the N-type doped polycrystalline silicon layer that is located on an edge region of the back surface to a thickness of the N-type doped polycrystalline silicon layer that is located on a central region of the back surface is any value greater than or equal to 1 and less than or equal to 1.2. For example, the ratio of the thickness of the N-type doped polycrystalline silicon layer that is located on the edge region of the back surface to the thickness of the N-type doped polycrystalline silicon layer that is located on the central region of the back surface is 1, 1.12, 1.14, 1.16, 1.18, or 1.2.

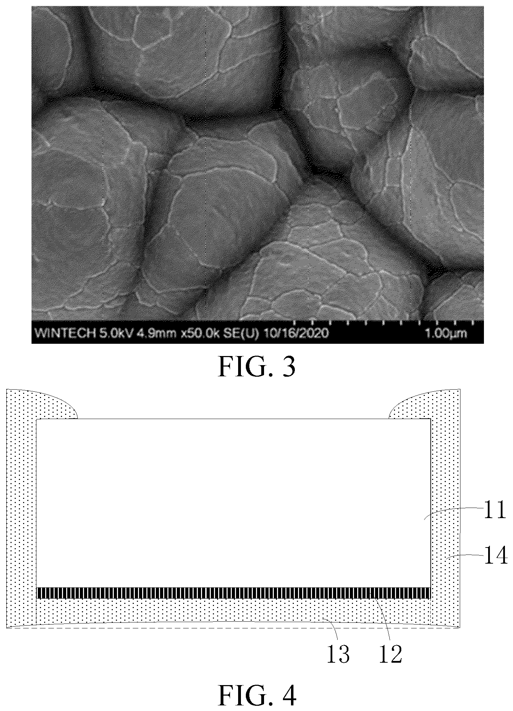

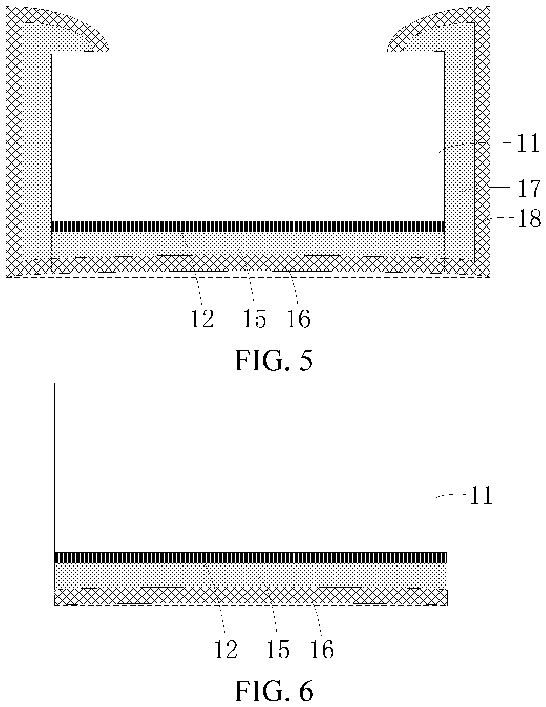

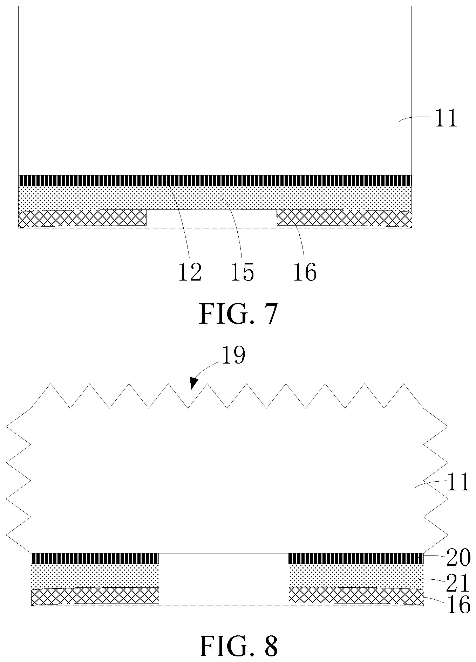

When the foregoing technical solution is used, a tunneling passivation contact structure that is formed by the tunneling passivation layer and the N-type doped polycrystalline silicon layer can achieve excellent interface passivation and carrier selective collection, facilitating improvement of photoelectric conversion efficiency of the back-contacted solar cell. In addition, compared with the related technology in which a ratio of a thickness of an edge part to a thickness of a central part of an N-type doped polycrystalline silicon layer (referring to FIG. 2) is greater than 1.3, in this embodiment of the present application, a ratio of a thickness of the N-type doped polycrystalline silicon layer that is located on an edge region of the back surface to a thickness of the N-type doped polycrystalline silicon layer that is located on a central region of the back surface is greater than or equal to 1 and less than or equal to 1.2. As shown in FIG. 1, in this case, a difference between the thickness of the edge part and the thickness of the central part of the N-type doped polycrystalline silicon layer 21 is small. In this case, in an actual manufacturing process, as shown in FIG. 4, a tunneling passivation material layer 12 and an intrinsic amorphous silicon material layer 13 used for manufacturing the tunneling passivation layer and the N-type doped polycrystalline silicon layer are usually formed by using a process such as chemical vapor deposition. Based on this, when the difference between the thickness of the edge part and the thickness of the central part of the N-type doped polycrystalline silicon layer is small, a difference between a thickness of an edge part and a thickness of a central part of the intrinsic amorphous silicon material layer 13 for forming the N-type doped polycrystalline silicon layer is also small. Because parts of the intrinsic amorphous silicon material layer 13 that are parallel to the back surface are all formed simultaneously, a chemical dose ratio of the intrinsic amorphous silicon material located on the edge region of the back surface to the intrinsic amorphous silicon material located on the central region of the back surface is approximately equal to 1. Therefore, when the difference between the thickness of the edge part and the thickness of the central part of the intrinsic amorphous silicon material layer 13 is small, a difference between structural compactness of the edge part and structural compactness of the central part of the intrinsic amorphous silicon material layer 13 is small (referring to FIG. 3). Correspondingly, as shown in FIG. 5, when the phosphorus diffusion treatment is performed on the intrinsic amorphous silicon material layer 13, a difference between compactness of an edge part of a phosphorus-silicon glass layer 16 obtained by a reaction between silicon in the intrinsic amorphous silicon material layer 13 and oxygen in a diffusion ambient and compactness of a central part of the phosphorus-silicon glass layer is also small, so that the edge part of the phosphorus-silicon glass layer 16 has high anti-corrosion performance that is approximately the same as that of the central part of the phosphorus-silicon glass layer. Therefore, in a process in which the texturing treatment is performed on at least the light facing surface of the semiconductor substrate 11, a part, which is used for forming the N-type doped polycrystalline silicon layer 21, of the N-type doped polycrystalline silicon material layer 15 located below the phosphorus-silicon glass layer 16 can be well protected by using the phosphorus-silicon glass layer (referring to FIG. 7 and FIG. 8), so that the morphology and the forming range of the obtained N-type doped polycrystalline silicon layer 21 satisfy a target requirement, thereby facilitating collection of carriers, reducing reverse leakage current, and further facilitating improvement of the photoelectric conversion efficiency of the back-contacted solar cell.

It can be known from the foregoing content that the magnitude of the ratio of the thickness of the N-type doped polycrystalline silicon layer that is located on the edge region of the back surface to the thickness of the N-type doped polycrystalline silicon layer that is located on the central region of the back surface affects the anti-corrosion performance of the phosphorus-silicon glass layer formed after the phosphorus diffusion treatment, and further affects the morphology of the phosphorus-silicon glass layer and the forming range of the phosphorus-silicon glass layer on a side of the back surface. Based on this, in the direction parallel to the back surface, a specific thickness of each part of the N-type doped polycrystalline silicon layer is determined according to requirements for the morphology of the N-type doped polycrystalline silicon layer and its forming range on a side of the back surface in an actual application scenario, provided that the specific thickness can be applied to the back-contacted solar cell provided in this embodiment of the present application.

For example, as shown in FIG. 1, the thickness of the N-type doped polycrystalline silicon layer 21 that is located on the edge region of the back surface is greater than or equal to 175 nm and less than or equal to 225 nm. For example, the thickness of the N-type doped polycrystalline silicon layer 21 that is located on the edge region of the back surface is 175 nm, 185 nm, 195 nm, 205 nm, 215 nm, or 225 nm. In this case, the thickness of the N-type doped polycrystalline silicon layer 21 located on the edge region of the back surface is within the foregoing range, to avoid a case that the overall thickness of the N-type doped polycrystalline silicon layer 21 is small because of the foregoing small thickness value and does not satisfy the target requirement, and avoid a case that the difficulty of manufacturing an N-type doped polycrystalline silicon layer 21 having high thickness uniformity is high, thereby facilitating obtaining of the back-contacted solar cell. In addition, a case that the anti-corrosion performance of the phosphorus-silicon glass layer located on the edge part of the N-type doped polycrystalline silicon material layer after the phosphorus diffusion treatment is poor due to the foregoing large thickness value can be further avoided, to ensure that the phosphorus-silicon glass layer in the process of performing the texturing treatment can well include the parts that are in the N-type doped polycrystalline silicon material layer and that are used for forming the N-type doped polycrystalline silicon layer 21, and ensure that the N-type doped polycrystalline silicon layer 21 has a good morphology and a forming range that satisfies the target requirement.

For example, as shown in FIG. 1, the thickness of the N-type doped polycrystalline silicon layer 21 that is located on the central region of the back surface is greater than or equal to 150 nm and less than or equal to 200 nm. For example, the thickness of the N-type doped polycrystalline silicon layer 21 that is located on the central region of the back surface is 150 nm, 160 nm, 170 nm, 180 nm, 190 nm, or 200 nm.

In terms of doping, the foregoing N-type doped polycrystalline silicon layer is doped with only such an N-type impurity as phosphorus, or is doped with such an N-type impurity as nitrogen or arsenic. A doping concentration of the impurity in the N-type doped polycrystalline silicon layer is set according to an actual requirement, which is not specifically limited herein.

For example, an average doping concentration of the N-type doped polycrystalline silicon layer is greater than or equal to 3.5 × 10²⁰/cm³ and less than or equal to 4.0 × 10²⁰/cm³. For example, the average doping concentration of the impurity in the N-type doped polycrystalline silicon layer is 3.5×10²⁰/cm³, 3.6×10²⁰/cm³, 3.7×10²⁰/cm³, 3.8×10²⁰/cm³, 3.9×10²⁰/cm³, or 4.0×10²⁰/cm³. In this case, the average doping concentration of the impurity in the N-type doped polycrystalline silicon layer is within the foregoing range, to properly reduce the doping concentration of the impurity in the N-type doped polycrystalline silicon layer in this embodiment of the present application compared with an N-type doped polycrystalline silicon layer (where the average doping concentration of the impurity in the N-type doped polycrystalline silicon layer is greater than 5.0 × 10²⁰/cm³) in the related technology, while ensuring that the N-type doped polycrystalline silicon layer has an excellent carrier selective collection function without affecting the contact resistance between the N-type doped polycrystalline silicon layer and the negative electrode. Correspondingly, an average doping concentration of the impurity in the N-type doped polycrystalline silicon material layer used for manufacturing the N-type doped polycrystalline silicon layer is also low. Based on this, in an actual manufacturing process, an average doping concentration of the impurity in the N-type doped polycrystalline silicon material layer after the phosphorus diffusion treatment is in direct proportion to an average doping concentration of the impurity in the phosphorus-silicon glass layer formed on the N-type doped polycrystalline silicon material layer after the phosphorus diffusion treatment. Therefore, properly reducing the doping concentration of the impurity in the N-type doped polycrystalline silicon layer also represents reduction of the average doping concentration of the impurity (the impurity includes phosphorus) in the phosphorus-silicon glass layer. In this case, because the doping concentration of phosphorus in the phosphorus-silicon glass layer is inversely proportional to the anti-corrosion performance of the phosphorus-silicon glass layer, properly reducing the doping concentration of phosphorus in the phosphorus-silicon glass layer can further improve the anti-corrosion performance of the phosphorus-silicon glass layer, to further ensure that the N-type doped polycrystalline silicon layer has a good morphology and a forming range that satisfies the target requirement.

In an actual application process, in a process of forming the N-type doped polycrystalline silicon layer on a side of the back surface, a doped layer deposited around and a phosphorus-silicon glass layer deposited around are formed on a side surface of the semiconductor substrate and a part of the light facing surface due to wrap-around. In addition, before the texturing treatment is performed on at least the light facing surface of the semiconductor substrate, it is necessary to sequentially remove the phosphorus-silicon glass layer deposited around and the doped layer deposited around. The corrosion liquid used to remove the doped layer deposited around also affects the surface of the part of the light facing surface of the semiconductor substrate that is covered by the doped layer deposited around. In this way, the surface of the part is formed with a cellular structure. However, the surface of the central region of the light facing surface of the semiconductor substrate that is not covered by the doped layer deposited around is flat. Consequently, after the subsequent texturing treatment, dimensions of the textured structures on the edge region and the central region of the light facing surface are inconsistent, thereby affecting the light trapping effect of the light facing surface. Specifically, the uniformity of the textured structures on the light facing surface is determined according to a formation situation of the N-type doped polycrystalline silicon layer, and is not specifically limited herein.

For example, as shown in FIG. 1, uniformity of the textured structure on the light facing surface is greater than or equal to 85% and less than 100%. A specific value of the uniformity of the textured structures on the light facing surface is determined according to an actual manufacturing process, and is not specifically limited herein. In this case, textured surfaces on the regions of the light facing surface have high uniformity, so that all the regions of the light facing surface have high light transmittance performance. Therefore, more light can be transmitted into the semiconductor substrate 11 through the light facing surface, thereby further improving the photoelectric conversion efficiency of the back-contacted solar cell.

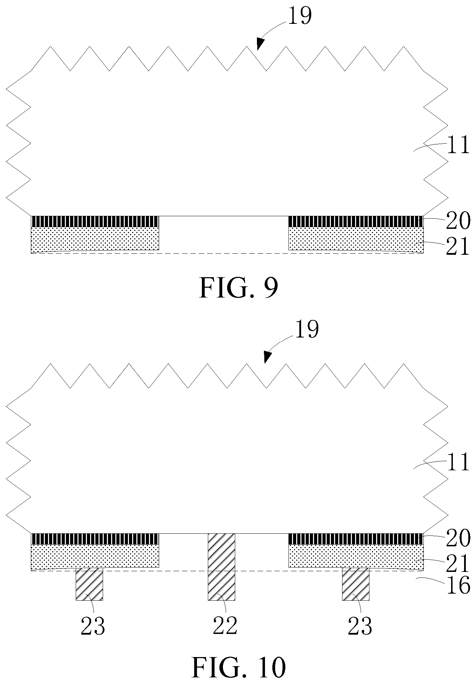

In some cases, as shown in FIG. 10, the back-contacted solar cell provided in this embodiment of the present application further includes a positive electrode 22 and a negative electrode 23. The positive electrode 22 is in ohmic contact with the P-type region of the semiconductor substrate 11. The negative electrode 23 is in ohmic contact with the N-type doped polycrystalline silicon layer 21. A material of the positive electrode 22 and the negative electrode 23 is a conductive material such as copper, aluminum, or silver.

According to a second aspect, an embodiment of the present application further provides a photovoltaic module. The photovoltaic module includes the back-contacted solar cell provided in the foregoing first aspect and the embodiments thereof.

For beneficial effects of the second aspect in this embodiment of the present application, reference is made to the analysis of the beneficial effects of the first aspect and various embodiments of the first aspect, and details are not described herein.

According to a third aspect, an embodiment of the present application further provides a manufacturing method for a back-contacted solar cell. A manufacturing process is described below according to cross-sectional views of operations shown in FIG. 4 to FIG. 10.

Specifically, the manufacturing method for a back-contacted solar cell includes: First, a semiconductor substrate is provided. Next, as shown in FIG. 4, a tunneling passivation material layer 12 and an intrinsic amorphous silicon material layer 13 are sequentially stacked on a side of a back surface of the semiconductor substrate 11 in a thickness direction of the semiconductor substrate 11. Next, as shown in FIG. 5, phosphorus diffusion treatment is performed on the intrinsic amorphous silicon material layer, to form an N-type doped polycrystalline silicon material layer 15 from the intrinsic amorphous silicon material layer, and form a phosphorus-silicon glass layer 16 on the N-type doped polycrystalline silicon material layer 15. A ratio of a thickness of the N-type doped polycrystalline silicon material layer 15 that is located on an edge region of the back surface to a thickness of the N-type doped polycrystalline silicon material layer 15 that is located on a central region of the back surface is greater than or equal to 1 and less than or equal to 1.2. Next, as shown in FIG. 8, texturing treatment is performed on a light facing surface of the semiconductor substrate 11 under a mask of the phosphorus-silicon glass layer 16, to form a textured surface 19 from the light facing surface. Next, as shown in FIG. 8, patterning treatment is performed on the phosphorus-silicon glass layer 16, and the tunneling passivation material layer and the N-type doped polycrystalline silicon material layer that are stacked, to form a tunneling passivation layer 20 and an N-type doped polycrystalline silicon layer 21 that are stacked on a local region of the back surface. Next, as shown in FIG. 9, the remaining phosphorus-silicon glass layer is removed.

For beneficial effects of the third aspect in this embodiment of the present application, reference is made to the analysis of the beneficial effects of the first aspect and various embodiments of the first aspect, and details are not described herein.

Specifically, for a specific structure, a conduction type, a material, and the like of the foregoing semiconductor substrate, reference is made to the foregoing description, and details are not described herein again. After the semiconductor substrate is provided, the tunneling passivation material layer and the intrinsic amorphous silicon material layer are formed by using a process such as chemical vapor deposition. For a material, a thickness, and the like of the tunneling passivation material layer, reference is made to the foregoing description. With regard to the intrinsic amorphous silicon material layer, the intrinsic amorphous silicon material layer is used for manufacturing an N-type doped polycrystalline silicon layer included in the back-contacted solar cell. In addition, the phosphorus-silicon glass layer formed after the phosphorus diffusion treatment needs to consume a part of silicon in the intrinsic amorphous silicon material layer. Consequently, after the phosphorus diffusion treatment, the thickness of the N-type doped polycrystalline silicon material layer formed based on the intrinsic amorphous silicon material layer is reduced. Based on this, the thickness of each part of the intrinsic amorphous silicon material layer is determined according to a ratio of the thickness of each part of the N-type doped polycrystalline silicon material layer and the phosphorus-silicon glass layer to the thickness of the intrinsic amorphous silicon material that needs to be consumed to form the phosphorus-silicon glass layer having a corresponding thickness.

For example, when an average thickness of the intrinsic amorphous silicon material layer is H1, an average thickness of the phosphorus-silicon glass layer is H2, and an average thickness of the N-type doped polycrystalline silicon material layer is H3, 40% of H2 < H1-H3 < 60% of H2. In this case, that the average thicknesses of the intrinsic amorphous silicon material layer, the phosphorus-silicon glass layer, and the N-type doped polycrystalline silicon material layer satisfy the foregoing condition indicates that the formation thickness of the intrinsic amorphous silicon material layer is proper, and the compactness and structural compactness uniformity of the regions of the intrinsic amorphous silicon material layer that are in a direction parallel to the back surface are both high. Therefore, after the phosphorus-silicon glass layer is formed, the consumed thickness of the N-type doped polycrystalline silicon material layer can satisfy a theoretical consumption amount of an N-type doped polycrystalline silicon material layer having high compactness (that is, the thickness of the phosphorus-silicon glass layer is roughly equal to half of a reduction amount of the thickness of the N-type doped polycrystalline silicon material layer), or has a small difference from the foregoing theoretical consumption amount, thereby indicating that the optimized phosphorus-silicon glass layer has high forming quality, and ensuring that the formed N-type doped polycrystalline silicon layer has a good morphology and a forming range that satisfies the target requirement.

In addition, a ratio of a thickness of the N-type doped polycrystalline silicon material layer formed based on the intrinsic amorphous silicon material layer that is located on an edge region of the back surface to a thickness of the N-type doped polycrystalline silicon material layer that is located on a central region of the back surface is greater than or equal to 1 and less than or equal to 1.2. Correspondingly, a ratio of a thickness of the intrinsic amorphous silicon material layer that is located on an edge region of the back surface to a thickness of the intrinsic amorphous silicon material layer that is located on a central region of the back surface is also greater than or equal to 1 and less than or equal to 1.2. In this case, in an actual manufacturing process, a thickness of a corresponding region of the intrinsic amorphous silicon material layer is regulated by adjusting any parameter that can affect formation thicknesses of different regions of the intrinsic amorphous silicon material layer, such as an ambient pressure or a gas flow rate when the intrinsic amorphous silicon material layer is formed. Specifically, a value of a specific parameter affecting the formation thicknesses of the different regions of the intrinsic amorphous silicon material layer is determined according to the specific formation thicknesses of the different regions of the intrinsic amorphous silicon material layer, provided that the parameter can be applied to the manufacturing method for a back-contacted solar cell provided in this embodiment of the present application.

For example, an ambient pressure for forming the intrinsic amorphous silicon material layer is greater than or equal to 100 mTorr and less than or equal to 150 mTorr. For example, the ambient pressure for forming the intrinsic amorphous silicon material layer is 100 mTorr, 110 mTorr, 120 mTorr, 130 mTorr, 140 mTorr, or 150 mTorr. In this case, in an actual process of manufacturing the intrinsic amorphous silicon material layer, in a specific range, reducing the ambient pressure can improve a molecular free path, to cause a reactive molecular group to reach various regions on the surface of the tunneling passivation material layer more quickly, rather than gather at a same position. Based on this, the ambient pressure for forming the intrinsic amorphous silicon material layer is within the foregoing range, to prevent a large thickness of the edge part of the intrinsic amorphous silicon material layer caused by a large ambient pressure, ensure that a difference between the thicknesses of the edge part and the central part of the intrinsic amorphous silicon material layer is small, and ensure that a structure of the edge part of the intrinsic amorphous silicon material layer is as compact as a structure of the central part of the intrinsic amorphous silicon material layer, so that each part, in a direction parallel to the back surface, of the phosphorus-silicon glass layer formed after the phosphorus diffusion treatment has high anti-corrosion performance, to ensure that the morphology and the forming range of the formed N-type doped polycrystalline silicon layer satisfy the target requirement. In addition, low manufacturing process efficiency caused by a low ambient pressure can also be prevented.

For example, a gas flow rate for forming the intrinsic amorphous silicon material layer is greater than or equal to 0.9 slm and less than or equal to 1.2 slm. For example, the gas flow rate for forming the intrinsic amorphous silicon material layer is 0.9 slm, 1.0 slm, 1.1 slm, or 1.2 slm. In this case, in an actual process of manufacturing the intrinsic amorphous silicon material layer, in a particular range, reducing a gas flow rate can reduce a total gas flow rate in a diffusion device, to reduce a disturbance degree caused by the gas flow in the diffusion device, facilitate optimization of deposition quality of a part of the intrinsic amorphous silicon material layer located on the edge region of the back surface, and ensure that a structure of the edge part of the intrinsic amorphous silicon material layer is as compact as a structure of the central part of the intrinsic amorphous silicon material layer, so that each part, in a direction parallel to the back surface, of the phosphorus-silicon glass layer formed after the phosphorus diffusion treatment has high anti-corrosion performance, to ensure that the morphology and the forming range of the formed N-type doped polycrystalline silicon layer satisfy the target requirement. In addition, low manufacturing process efficiency caused by a low gas flow rate can also be prevented.

It should be noted that, as shown in FIG. 4, an amorphous silicon layer 14 is formed as well on a side surface of the semiconductor substrate 11 and a part of the light facing surface while the intrinsic amorphous silicon material layer 13 is formed on the side of the back surface of the semiconductor substrate 11 in the thickness direction of the semiconductor substrate 11. The width of the formation region of the amorphous silicon layer 14 on the light facing surface (the width direction of the formation region is parallel to the radial direction of the semiconductor substrate 11) is affected by parameters such as an ambient pressure and a gas flow rate when the intrinsic amorphous silicon material layer 13 is manufactured. For example, within a particular range, a smaller ambient pressure when the intrinsic amorphous silicon material layer 13 is manufactured indicates a smaller width of the formation region of the amorphous silicon layer 14 on the light facing surface. In the foregoing case, the width of the formation region of the amorphous silicon layer 14 on the light facing surface is determined according to a manufacturing situation of the intrinsic amorphous silicon material layer 13.

For example, the width of the formation region of the amorphous silicon layer on the light facing surface is greater than or equal to 0 and less than 10 mm. For example, the width of the formation region of the amorphous silicon layer on the light facing surface is 1 mm, 3 mm, 6 mm, 9 mm, or 9.5 mm. In this case, before the texturing treatment is performed, it is necessary to sequentially remove the phosphorus-silicon glass layer deposited around and the doped layer deposited around that are formed due to wrap-around. The corrosion liquid used to remove the doped layer deposited around also affects the surface of the part of the light facing surface of the semiconductor substrate that is covered by the doped layer deposited around. In this way, the surface of the part is formed with a cellular structure. However, the surface of the central region of the light facing surface of the semiconductor substrate that is not covered by the doped layer deposited around is flat. Consequently, after the subsequent texturing treatment, dimensions of the textured structures on the edge region and the central region of the light facing surface are inconsistent, thereby affecting the light trapping effect of the light facing surface. In this case, compared with a related technology in which a width of a formation region of a doped layer deposited around, on a light facing surface, that is formed when a back-contacted solar cell is manufactured is greater than 10 mm, in this embodiment of the present application, when a width of a formation region of the amorphous silicon layer on the light facing surface is greater than or equal to 0 and less than 10 mm, a wrap-around width thereof is small, which facilitates improvement of uniformity of textured structures located on regions of the light facing surface, further facilitates improvement of a light trapping effect of the light facing surface, and further improves photoelectric conversion efficiency of the back-contacted solar cell. Therefore, it can be learned that a specific value of the uniformity of the textured structures on the light facing surface of the semiconductor substrate is determined according to the width of the formation region of the amorphous silicon layer on the light facing surface and the dimension of the semiconductor substrate in an actual manufacturing process, and is not specifically limited herein.

In an actual manufacturing process, after the foregoing intrinsic amorphous silicon material layer is formed, phosphorus diffusion treatment needs to be performed on the intrinsic amorphous silicon material layer, to form the N-type doped polycrystalline silicon material layer and the phosphorus-silicon glass layer. The phosphorus diffusion treatment includes a phosphorus source deposition step, an advancing and crystallization step, and a post-oxidation step that are sequentially performed. The foregoing phosphorus source deposition step can regulate the phosphorus doping concentrations in the N-type doped polycrystalline silicon material layer and the phosphorus-silicon glass layer, and the foregoing post-oxidation step can regulate the thicknesses of the N-type doped polycrystalline silicon material layer and the phosphorus-silicon glass layer. In addition, both the phosphorus doping concentrations in the N-type doped polycrystalline silicon material layer and the phosphorus-silicon glass layer and the thickness of the phosphorus-silicon glass layer affect the anti-corrosion performance of the phosphorus-silicon glass layer in the texturing treatment process. Based on this, a specific process parameter of the phosphorus diffusion treatment is determined according to the thicknesses and the doping concentrations of the N-type doped polycrystalline silicon material layer and the phosphorus-silicon glass layer, and requirements for the morphology and the forming range of the N-type doped polycrystalline silicon layer in an actual application scenario. This is not specifically limited herein.

For example, a condition of the phosphorus diffusion treatment is as follows:
A deposition process temperature is greater than or equal to 850°C and less than or equal to 900°C. For example, the deposition process temperature is 850°C, 860°C, 870°C, 880°C, 890°C, or 900°C.

A deposition process ambient pressure is greater than or equal to 150 mbar and less than or equal to 200 mbar. For example, the deposition process ambient pressure is 150 mbar, 160 mbar, 170 mbar, 180 mbar, 190 mbar, or 200 mbar.

A phosphorus source pressure is greater than or equal to 250 mbar and less than or equal to 450 mbar. For example, the phosphorus source pressure is 250 mbar, 300 mbar, 350 mbar, 400 mbar, or 450 mbar.

A nitrogen flow rate is greater than or equal to 1500 sccm and less than or equal to 2000 sccm. For example, the nitrogen flow rate is 1500 sccm, 1600 sccm, 1700 sccm, 1800 sccm, 1900 sccm, or 2000 sccm.

An oxygen flow rate is greater than or equal to 750 sccm and less than or equal to 1000 sccm. For example, the oxygen flow rate is 750 sccm, 800 sccm, 850 sccm, 900 sccm, 950 sccm, or 1000 sccm.

A temperature in post-oxidation process is greater than or equal to 850°C and less than or equal to 900°C. For example, the temperature in post-oxidation process is 850°C, 860°C, 870°C, 880°C, 890°C, or 900°C.

An oxygen flow rate in post-oxidation process is greater than or equal to 5000 sccm and less than or equal to 10000 sccm. For example, the oxygen flow rate in post-oxidation process is 5000 sccm, 6000 sccm, 7000 sccm, 8000 sccm, 9000 sccm, or 10000 sccm.

Any one of the foregoing process parameters satisfies a corresponding range requirement, or at least two of the foregoing process parameters satisfy corresponding range requirements.

When the foregoing technical solution is used, in an actual manufacturing process, by changing the deposition process temperature, the deposition process ambient pressure, the phosphorus source pressure, the nitrogen flow rate, and the oxygen flow rate during the foregoing phosphorus diffusion treatment, the average doping concentration of the impurity in the formed phosphorus-silicon glass layer and the average doping concentration of the impurity in the formed N-type doped polycrystalline silicon material layer can be regulated. Based on this, when at least one of the deposition process temperature, the deposition process ambient pressure, the phosphorus source pressure, the nitrogen flow rate, and the oxygen flow rate falls within the foregoing corresponding range, the average doping concentration of phosphorus in the phosphorus-silicon glass layer can be properly reduced, so that the phosphorus-silicon glass layer has high anti-corrosion performance, thereby ensuring that the N-type doped polycrystalline silicon layer formed based on the N-type doped polycrystalline silicon material layer has a good morphology and a forming range that satisfies the target requirement. In addition, the thickness of the formed phosphorus-silicon glass layer can be regulated by changing the temperature in post-oxidation process and the oxygen flow rate in post-oxidation process during the phosphorus diffusion treatment. Based on this, when at least one of the temperature in post-oxidation process and the oxygen flow rate in post-oxidation process falls within the foregoing corresponding range, the formation thickness of the phosphorus-silicon glass layer can be properly increased, thereby improving the anti-corrosion performance of the phosphorus-silicon glass layer.

For example, a thickness of the phosphorus-silicon glass layer is greater than or equal to 60 nm and less than or equal to 65 nm. For example, the thickness of the phosphorus-silicon glass layer is 60 nm, 61 nm, 62 nm, 63 nm, 64 nm, or 65 nm. In this case, the thickness of the phosphorus-silicon glass layer is within the foregoing range, to avoid a case that the anti-corrosion performance of the phosphorus-silicon glass layer is poor due to a small thickness of the phosphorus-silicon glass layer, and ensure that the morphology and the forming range of the formed N-type doped polycrystalline silicon layer satisfy the target requirement. In addition, a case that a large quantity of consumables for manufacturing the intrinsic amorphous silicon material layer and the phosphorus-silicon glass layer are used due to a large thickness of the phosphorus-silicon glass layer can be further avoided, to facilitate control of manufacturing costs of the back-contacted solar cell.

It should be noted that, as shown in FIG. 5, after the phosphorus diffusion treatment, a doped layer deposited around 17 is formed from the amorphous silicon layer, and a phosphorus-silicon glass layer deposited around 18 is formed on the doped layer deposited around 17. In this case, after the foregoing N-type doped polycrystalline silicon material layer 15 is formed, and before the texturing treatment is performed on at least the light facing surface of the semiconductor substrate 11, as shown in FIG. 6, a process such as wet etching is used to sequentially remove the phosphorus-silicon glass layer deposited around and the doped layer deposited around.

In addition, after the phosphorus diffusion treatment is performed on the intrinsic amorphous silicon material layer, and before the texturing treatment is performed on at least the light facing surface of the semiconductor substrate, as shown in FIG. 7, a manner such as laser etching is used to perform the patterning treatment only on the phosphorus-silicon glass layer 16, and a part of the phosphorus-silicon glass layer 16 remained on a local region of the N-type doped polycrystalline silicon material layer 15. In this case, as shown in FIG. 8, patterning treatment is performed on the tunneling passivation material layer and the N-type doped polycrystalline silicon material layer that are stacked under the mask of the phosphorus-silicon glass layer 16 while texturing treatment is performed on the light facing surface of the semiconductor substrate 11. In other words, patterning treatment is performed on the phosphorus-silicon glass layer 16 on a side of the back surface before the texturing treatment is performed, so that in a subsequent process of the texturing treatment, a texturing corrosion liquid not only can form a textured surface 19 on at least the light facing surface, but also can implement, under the mask of the remaining part of the phosphorus-silicon glass layer 16, patterning treatment on the N-type doped polycrystalline silicon material layer and the tunneling passivation material layer, to obtain the N-type doped polycrystalline silicon layer 21 and the tunneling passivation layer 20, thereby improving the manufacturing process efficiency of the back-contacted solar cell while ensuring that the morphology and the forming range of the N-type doped polycrystalline silicon layer 21 satisfy the target requirement.

Certainly, the texturing treatment is alternatively performed on at least the light facing surface of the semiconductor substrate directly under the mask of the entire phosphorus-silicon glass layer after the phosphorus-silicon glass layer deposited around and the doped layer deposited around are removed. In this case, the texturing corrosion liquid does not affect any region of the N-type doped polycrystalline silicon material layer that is parallel to the back surface. In this case, after the texturing treatment is performed, a manner such as laser etching is used to perform patterning treatment on the phosphorus-silicon glass layer, and then a manner such as wet etching or dry etching is used to perform patterning treatment on the tunneling passivation material layer and the N-type doped polycrystalline silicon material layer under the mask of the remaining part of the phosphorus-silicon glass layer, to obtain the tunneling passivation layer and the N-type doped polycrystalline silicon layer.

Next, as shown in FIG. 9, a process such as wet etching or dry etching is used to remove the remaining part of the phosphorus-silicon glass layer. Next, as shown in FIG. 10, the positive electrode 22 and the negative electrode 23 are formed on a side of the back surface in a manner such as screen printing or electroplating. The positive electrode 22 is in ohmic contact with the P-type region of the semiconductor substrate 11. The negative electrode 23 is in ohmic contact with the N-type doped polycrystalline silicon layer 21.

The foregoing described apparatus embodiments are merely examples. The units described as separate parts may or may not be physically separate, and the parts displayed as units may or may not be physical units, may be located in one position, or may be distributed on a plurality of network units. Some or all of the modules may be selected according to actual needs to achieve the objectives of the solutions of the embodiments. Persons of ordinary skill in the art may understand and implement the present application without creative efforts.

"One embodiment", "an embodiment", or "one or more embodiments" mentioned in this specification mean that particular features, structures, or characteristics described with reference to the embodiments may be included in at least one embodiment of the present application. In addition, it should be noted that the phrase example of "in an embodiment" does not necessarily refer to a same embodiment. In the specification provided herein, a large number of specific details are described. However, it may be understood that, the embodiments of the present application may be practiced without these specific details. In some embodiments, well-known methods, structures, and technologies are not shown in detail, so as not to obscure understanding of this specification.

In the claims, any reference signs between brackets should not be constructed as a limitation to the claims. The word "including" does not exclude elements or steps that are not listed in a claim. The word "one" or "a" before an element does not exclude a plurality of such elements. The present application may be implemented by using hardware including a plurality of different elements, and by using a properly programmed computer. In a unit claim enumerating a plurality of apparatuses, some of these apparatuses may be specifically embodied by a same hardware item. The use of the words first, second, and third does not indicate any order. These words may be explained as names.

Finally, it should be noted that, the foregoing embodiments are merely used for describing the technical schemes of the present application, but are not intended to limit the present application. Although the present application is described in detail with reference to the foregoing embodiments, it should be understood that a person of ordinary skill in the art may still make modifications to the technical schemes described in the foregoing embodiments or make equivalent replacements to some technical features thereof, without departing from the spirit and scope of the technical solutions of the embodiments of the present application.

## Claims

1. A back-contacted solar cell, comprising:
a semiconductor substrate, wherein the semiconductor substrate has a first surface and a second surface arranged opposite to each other, and the first surface has a textured structure;
and a tunneling passivation layer and an N-type doped polycrystalline silicon layer that are sequentially stacked on a local region of the second surface in a thickness direction of the semiconductor substrate, wherein a ratio of a thickness of the N-type doped polycrystalline silicon layer that is located on an edge region of the second surface to a thickness of the N-type doped polycrystalline silicon layer that is located on a central region of the second surface is greater than or equal to 1 and less than or equal to 1.2.

2. The back-contacted solar cell according to claim 1, wherein uniformity of the textured structure on the first surface is greater than or equal to 85% and less than 100%.

3. The back-contacted solar cell according to claim 1, wherein a region of the second surface on which the tunneling passivation layer and the N-type doped polycrystalline silicon layer are not stacked is a polished surface or a textured structure.

4. The back-contacted solar cell according to claim 1, wherein the thickness of the N-type doped polycrystalline silicon layer that is located on the edge region of the second surface is greater than or equal to 175 nm and less than or equal to 225 nm; and/or
the thickness of the N-type doped polycrystalline silicon layer that is located on the central region of the second surface is greater than or equal to 150 nm and less than or equal to 200 nm.

5. The back-contacted solar cell according to any one of claims 1 to 4, wherein an average doping concentration of the N-type doped polycrystalline silicon layer is greater than or equal to 3.5 × 10²⁰/cm³ and less than or equal to 4.0 × 10²⁰/cm³.

6. A photovoltaic module, comprising: the back-contacted solar cell according to any one of claims 1 to 5.

7. A manufacturing method for a back-contacted solar cell, comprising:
providing a semiconductor substrate, wherein the semiconductor substrate has a first surface and a second surface arranged opposite to each other;
sequentially stacking a tunneling passivation material layer and an intrinsic amorphous silicon material layer on a side of the second surface in a thickness direction of the semiconductor substrate;
performing phosphorus diffusion treatment on the intrinsic amorphous silicon material layer, to form an N-type doped polycrystalline silicon material layer from the intrinsic amorphous silicon material layer, and form a phosphorus-silicon glass layer on the N-type doped polycrystalline silicon material layer, wherein a ratio of a thickness of the N-type doped polycrystalline silicon material layer that is located on an edge region of the second surface to a thickness of the N-type doped polycrystalline silicon material layer that is located on a central region of the second surface is greater than or equal to 1 and less than or equal to 1.2;
performing texturing treatment on the first surface to form a textured surface from the first surface under a mask of the phosphorus-silicon glass layer;
performing patterning treatment on the phosphorus-silicon glass layer, the tunneling passivation material layer and the N-type doped polycrystalline silicon material layer that are stacked, to form a tunneling passivation layer and an N-type doped polycrystalline silicon layer that are stacked on a local region of the second surface; and
removing the remaining phosphorus-silicon glass layer.

8. The manufacturing method for a back-contacted solar cell according to claim 7, wherein an ambient pressure for forming the intrinsic amorphous silicon material layer is greater than or equal to 100 mTorr and less than or equal to 150 mTorr; and/or
a gas flow rate for forming the intrinsic amorphous silicon material layer is greater than or equal to 0.9 slm and less than or equal to 1.2 slm.

9. The manufacturing method for a back-contacted solar cell according to claim 7, wherein after the performing phosphorus diffusion treatment on the intrinsic amorphous silicon material layer, and before the performing texturing treatment on the first surface under a mask of the phosphorus-silicon glass layer, the patterning treatment is performed only on the phosphorus-silicon glass layer, and a part of the phosphorus-silicon glass layer remained on a local region of the N-type doped polycrystalline silicon material layer; and
patterning treatment is performed on the tunneling passivation material layer and the N-type doped polycrystalline silicon material layer that are stacked under the mask of the phosphorus-silicon glass layer while texturing treatment on the first surface.

10. The manufacturing method for a back-contacted solar cell according to claim 7, wherein an amorphous silicon layer is formed as well on a side surface of the semiconductor substrate and a part of the first surface while the intrinsic amorphous silicon material layer is formed on the second surface in the thickness direction of the semiconductor substrate; a width of a formation region of the amorphous silicon layer on the first surface is greater than or equal to 0 and less than 10 mm; a width direction of the formation region is parallel to a radial direction of the semiconductor substrate;
after the phosphorus diffusion treatment, a doped layer deposited around is formed from the amorphous silicon layer, and a phosphorus-silicon glass layer deposited around is formed on the doped layer deposited around; and
after the performing phosphorus diffusion treatment on the intrinsic amorphous silicon material layer, and before the performing texturing treatment on the first surface under a mask of the phosphorus-silicon glass layer, the manufacturing method for a back-contacted solar cell further comprises: removing the phosphorus-silicon glass layer deposited around and the doped layer deposited around.

11. The manufacturing method for a back-contacted solar cell according to any one of claims 7 to 10, wherein a thickness of the phosphorus-silicon glass layer is greater than or equal to 60 nm and less than or equal to 65 nm; and/or
an average thickness of the intrinsic amorphous silicon material layer is H1, an average thickness of the phosphorus-silicon glass layer is H2, an average thickness of the N-type doped polycrystalline silicon material layer is H3, and 40% of H2 < H1-H3 < 60% of H2.

12. The manufacturing method for a back-contacted solar cell according to any one of claims 7 to 10, wherein a condition of the phosphorus diffusion treatment is:
a deposition process temperature is greater than or equal to 850°C and less than or equal to 900°C; and/or a deposition process ambient pressure is greater than or equal to 150 mbar and less than or equal to 200 mbar; and/or a phosphorus source pressure is greater than or equal to 250 mbar and less than or equal to 450 mbar; and/or a nitrogen flow rate is greater than or equal to 1500 sccm and less than or equal to 2000 sccm; and/or an oxygen flow rate is greater than or equal to 750 sccm and less than or equal to 1000 sccm; and/or a temperature in post-oxidation process is greater than or equal to 850°C and less than or equal to 900°C; and/or an oxygen flow rate in post-oxidation process is greater than or equal to 5000 sccm and less than or equal to 10000 sccm.
